# EUROPEAN PATENT APPLICATION

(11) **EP 1 669 782 A2**
(43) Date of publication of application: **14.06.2006**
(21) Application number: 05001077.6
(22) Date of filing: 20.01.2005
(51) Int. Cl.: G02B 6/00, G03F 7/00

(54) **Producing method of stamper for light guide plate**

(30) Priority: 07.12.2004 KR 2004102225
(71) Applicant: TAESAN LCD CO.,LTD., Kyungki-do (KR)
(72) Inventor: Choi, Tae-Hyun, Kangnam-gu Seoul (KR)
(74) Representative: Dr. Weitzel & Partner

(57) **Abstract**

Disclosed is a producing method of a stamper for a light guide plate, wherein the method includes the steps of: cleansing a conductor layer deposited layer; plating the conductor layer with a conductive material; spin coating a photoresist on the plating layer; placing a desired pattern mask, exposing and developing; wet etching the plating layer in a portion where the photoresist is partially removed; removing the remaining photoresist; fabricating a master by nickel plating a completed pattern surface; and releasing the master and nickel plating the master again to produce a stamper.

## Description

### BACKGROUND OF THE INVENTION

### Field of the Invention:

The present invention relates in general to a producing method of a stamper for a light guide plate, more specifically to a producing method of a wet etched stamper employing a plating process technology.

### Description of the Related Art

When an LCD (Liquid Crystal Display) device was first developed for use in computer monitors, notebook PCs, and flat TVs, it was rather easy to see characters with the clear distinction between a light-transmitting region and a light-intercepting region but this was possible only in the presence of an external light source with high luminance. Without any external light source present, users had a difficult time to read characters in a dark place. An LCD with a BLU (Back Light Unit) was then developed to help the users to be able to see the screen more clearly even in the absence of an external light source, as in a cathode ray tube. The BLU was installed at the rear side of the LCD, taking visual recognition into consideration, so that the screen display state can be visually recognized. A widely-used LCD in recent years includes a fluorescent lamp disposed at a side as a light source; a light guide plate for reflecting a light emitted from the fluorescent lamp to an LCD panel; a case and a reflector sheet disposed at the lower portion of the light guide plate, in which the reflector sheet reflects otherwise lost light to minimize a loss of the light; a first diffuser sheet disposed at the upper portion of the light guide plate for diffusing an incident light on the LCD panel; a vertical and horizontal prism sheet for condensing the diffused light; a secondary diffuser sheet disposed on the upper portion of the prism sheet for diffusing the light emitted from the prism sheet at a designated angle; and the LCD panel disposed at the upper portion of the secondary diffuser sheet.

Among other components, the light guide plate plays a key role in the LCD. There are several methods for manufacturing the light guide plate.

First of all there is a printing method. According to this method, a light scattering ink was screen printed on the lower portion of the light guide plate to vertically scatter an incident light and emit the light. However the printing method had a low light efficiency (or light-guide efficiency), and many safety problems were present at high temperature and high humidity. Also, since the printing process had to be repeated after the light guide plate was molded, production efficiency or yield of light guide plates was pretty low.

A number of non-printing methods were then developed to overcome the above problems. An etching method is a good example of those non-printing methods. According to the etching method, a photoresist was first coated and a pattern film was deposited thereon. Later the film was exposed, developed and chemically etched. Even though a desired pattern could be easily obtained by using this method, etching density and reaction time were difficult to control. As a result, reproducibility was not satisfactory. Also, transparency for forming a pattern surface in a desired size was found to be defective.

Many technologies were introduced to enhance the light efficiency (or the light-guide efficiency) of the light guide plate. Examples of such attempts include Sandblast, V-Cut, and stamper technologies.

However, the sandblast technology turned out to be very susceptive to a change in injection conditions, and a distribution of brightness on the screen varied accordingly. In the case of the V-Cut technology, although it featured excellent light-guide efficiency and reproducibility, an excessive amount of time required for the cleansing process and others outweighed such merits, proving that the V-Cut technology was not suitable for the mass production of light guide plates. The typical stamper technology involves a photoresist to form a micro lens array at an appropriate temperature. Unfortunately however, this technology also had weak points in that the size and the thickness of a lens pattern could not be adjusted at the same time. Because the thickness of the lens pattern was determined on the basis of the density of a fabricated photoresist and the reflow conditions, it was impossible to make micro lens arrays of the same thickness but with different sized patterns. In addition, patterning on a prism light guide plate and adjusting size, height and density thereof at the same time were not easy to do, so it seemed very difficult to manufacture a light guide plate the way the light guide plate was originally designed.

### SUMMARY OF THE INVENTION

It is, therefore, an object of the present invention to provide a producing method of a stamper for a light guide plate, in which the method features an easy control on making a change in the size of a pattern and the height of a lens, and creation of multi-patterns through a simplified process, thereby maintaining high brightness of a light.

To achieve the above objects and advantages, there is provided a producing method of a reflective-type stamper for a light guide plate, wherein the method is based on a photographic etching process technology used in semiconductor industries and a plating process technology used in the MEMS field.

In an exemplary embodiment of the present invention, the producing method of a stamper for a light guide plate includes the steps of: cleansing a conductor layer deposited layer; plating the conductor layer with a conductive material; spin coating a photoresist on the plating layer; placing a desired pattern mask, exposing and developing; wet etching the plating layer in a portion where the photoresist is partially removed; removing the remaining photoresist; fabricating a master by nickel plating a completed pattern surface; and releasing the master and nickel plating the released master again to produce a stamper.

### BRIEF DESCRIPTION OF THE DRAWINGS

The above aspects and features of the present invention will be more apparent by describing certain embodiments of the present invention with reference to the accompanying drawings, in which:

Fig. 1 is a flow chart describing a producing method of a stamper for a light guide plate according to the present invention; and

Fig. 2a to Fig. 2f are cross-sectional views illustrating each step of the producing method of a stamper according to the present invention.

### DETAILED DESCRIPTION OF THE PREFERRED EMBODIMENTS

A preferred embodiment of the present invention will be described herein below with reference to the accompanying drawings.

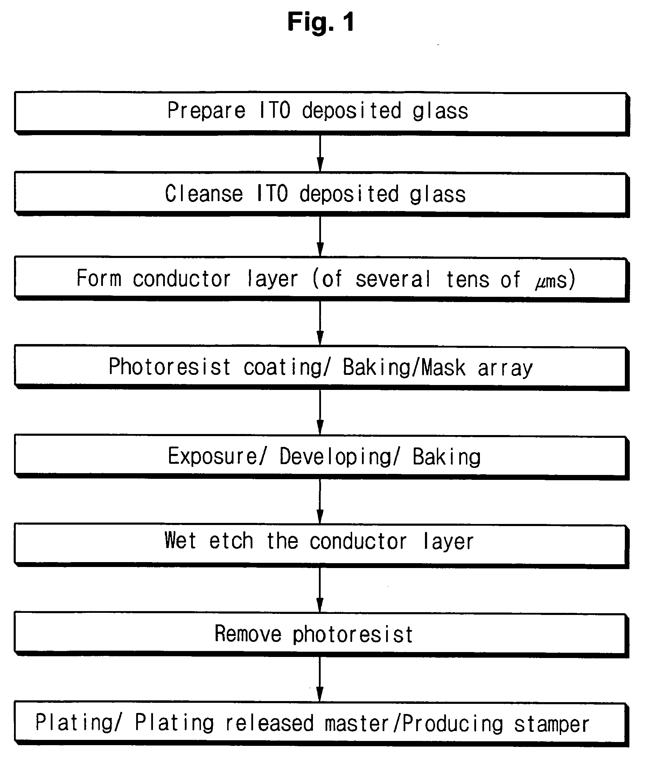

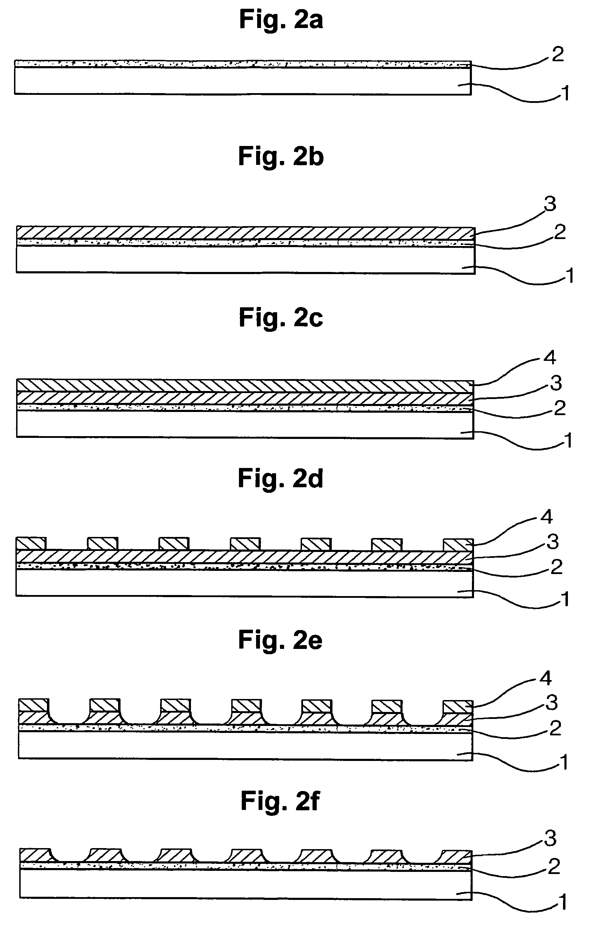

Fig. 1 is a flow chart describing a producing method of a stamper for a light guide plate according to the present invention; and Fig. 2a to Fig. 2f are cross-sectional views illustrating each step of the producing method of the stamper.

First of all, a glass 1 having a conductor layer deposited thereon was cleansed (Fig. 2a). Preferably, the conductor layer is an Indium Tin Oxide (ITO). Instead of employing the conductor layer deposited glass, a conductive material can be deposited on the glass by using the vacuum deposition technology.

As shown in Fig. 2b, a conductive material is plated on the conductor layer (i.e., the ITO). Examples of the conductive material include metals such as copper, nickel and chrome. In general, the thickness of the metal plating on the conductor layer can be varied, but it is preferably within several tens of micrometers. A photoresist 4 was then spin coated on the metal plated layer 3 (Fig. 2c). A desired pattern mask was placed on the top to expose the photoresist 4. The pattern mask was developed through the exposed photoresist 4 (Fig. 2d).

The metal plated layer 3 without the photoresist 4 on the top (i.e., a portion where the photoresist is partially removed) is wet etched (Fig. 2e). In other words, the metal plated layer (such as, the copper, nickel or chrome plated layer) is removed by wet etching. A typically used etching solution for the wet etching process is a mixture of nitric acid and ultra pure water, or a mixture of sulfuric acid, peroxide and ultra pure water. It is important that the etching solution has no influence on the photoresist used as a protection purpose and the conductor layer deposited on the surface of the glass. Preferably, the metal plated layer is thoroughly wet etched until the border surface between the conductor layer and the metal plated layer was gone.

In effect, the metal plated layer (such as, the copper, nickel or chrome plated layer) can be formed in such a manner that it has the same thickness with a desired pattern thickness. By wet etching the metal plated layer to a designated depth, one can completely resolve the height deviation between the resulting height of the metal plated layer and the desired pattern thickness.

Next, the remaining photoresist was removed (Fig. 2f), and a master was fabricated by plating the pattern surface with nickel. Then the master was released and plated one more time in order to produce a stamper.

In conclusion, by applying the present invention method to the manufacture of a light guide plate featuring an optimized light diffusion effect, it becomes easier to fix the pattern size, change or diversity the pattern size, and adjust the distance between the patterns. Moreover, the depth of the pattern can be more accurately and uniformly controlled by employing the vacuum deposition and plating technologies. These advantages are eventually led to the improvement of reproducibility, the maintenance of uniform brightness, and the enhancement of the light diffusion effect.

The foregoing embodiment and advantages are merely exemplary and are not to be construed as limiting the present invention. The present teaching can be readily applied to other types of apparatuses. Also, the description of the embodiments of the present invention is intended to be illustrative, and not to limit the scope of the claims, and many alternatives, modifications, and variations will be apparent to those skilled in the art.

## Claims

1. A producing method of a stamper for a light guide plate, the method comprising the steps of:
cleansing a conductor layer deposited layer;
plating the conductor layer with a conductive material;
spin coating a photoresist on the plating layer;
placing a desired pattern mask, exposing and developing;
wet etching the plating layer in a portion where the photoresist is partially removed;
removing the remaining photoresist;
fabricating a master by nickel plating a completed pattern surface; and
releasing the master and nickel plating the released master again to produce a stamper.

2. The method according to claim 1, wherein the conductive material is selected from copper, nickel and chrome.

3. The method according to claim 1, wherein the etching depth is same with the thickness of the plating layer.

4. The method according to claim 1, wherein an etching solution for use in the etching process is a mixture of nitric acid and ultra pure water, or a mixture of sulfuric acid, peroxide and ultra pure water.
